Europäisches Patentamt

European Patent Office

Office européen des brevets

(11) Publication number: **0 213 664**
**A1**

(12) **EUROPEAN PATENT APPLICATION**

(21) Application number: **86201359.6**

(22) Date of filing: **01.08.86**

(51) Int. Cl.⁴: **H01J 37/30** , H01J 37/317 , H01J 37/153

(30) Priority: **19.08.85 NL 8502275**

(43) Date of publication of application:
**11.03.87 Bulletin 87/11**

(84) Designated Contracting States:
**CH DE FR GB LI NL**

(71) Applicant: **N.V. Philips' Gloeilampenfabrieken**
**Groenewoudseweg 1**
**NL-5621 BA Eindhoven(NL)**

(72) Inventor: **Van Der Mast, Karel Diederick**
**c/o INT. OCTROOIBUREAU B.V. Prof.**
**Holstlaan 6**
**NL-5656 AA Einhoven(NL)**

(74) Representative: **Scheele, Edial François et al**
**INTERNATIONAAL OCTROOIBUREAU B.V.**
**Prof. Holstlaan 6**
**NL-5656 AA Eindhoven(NL)**

(54) **Beam of charged particles divided up into thin component beams.**

(57) In a charged-particle pattern generator, such as an electron-beam pattern generator, use is made of a beam or more commonly of a fan of beams whose diameter is sufficiently small to minimize the trajectory displacement effect. For the fan of beams it is preferred that the mutual distance of the component beams should be sufficiently large to minimize mutual trajectory displacement effects. By shaping the beam with a collection of solid-state of field-emitters very fast control can be realized and for example spherical aberration can be corrected in a simple manner by applying a matched potential excursion to the emitters. In this way it is also possible with simple means to apply dynamic brightness correction.

FIG.1

## Beam of charged particles divided up into thin component beams.

The invention relates to a charged-particle pattern generator containing a source and an optical system for generating and controlling a beam of charged particles.

A charged-particle pattern generator of this kind, in the form of an electron-beam pattern generator, is known form US 4151422. In a generator of this kind a beam of charged particles is used for producing integrated circuit elements, either by direct bombardment of a suitably equiped wafer of semiconducting material or by bombardment of an appropriate mask.

In practice it proves to be difficult to realize a beam or a fan of beams of sufficiently high current strength without disturbing effects arising due to mutual Coulomb repulsion of the charged particles during the passage of the beam through the generator. These disturbances are more serious when relatively long beam trajectories are used or relatively low accelerating voltages, and may be divided into statistical and non-statistical effects. The main cause of the statistical effect is that the distribution of charged particles in the beam is not constant and the force which these particles exert upon each other shows statistical fluctuations with time and among the particles. In so so far as these forces are axially directed, this results in changes of the velocity of the particles in the direction of propagation of the beam. This effect is known as the Boersch effect. The radial component of these forces causes a statistically fluctuating change in the direction of the particles in the beam. This effect is called trajectory displacement. For describing the second, non-statistical effect the charge may be regarded as uniform over the beam. The result of this effect is therefore a uniform beam spread. This will be referred to hereinafter as beam spread due to space charge. The necessary consequences of this can be reduced by suitable lens action.

When all factors that contribute to the form and current-density of the beam in a given charged-particle pattern generator have been optimized, which involves all kinds of constraints, it is found that for the beams required in this case the mutual repulsion of the charged particles is the limiting factor both for peripheral sharpness, mainly caused by the statistical change in direction·of the particle trajectories, and for image distortion, caused by the non-statistical beam spread. Conversely, it can also be said that for a given specification of the peripheral sharpness produced by the beam of charged paticles, this effect limits the current strength in the beam. To the extent that the phenomenon of statistical mutual repulsion is understood, efforts have been made to reduce its adverse effects on the beam by seeking to impose appropriate conditions for the beams, such as for example higher accelerating voltages, low current densities in the beams by admitting beams with the maximum usable lateral cross-section, short beam trajectories, and so on.

The object of the invention is to overcome the above-mentioned drawbacks and avoid limitations by shaping beams in which the aforesaid disturbing effects are to a great extent reduced.

A charged-particle pattern generator of the kind mentioned in the preamble is characterized in accordance with the invention in that beam-selection means are present for shaping a beam of charged particles which, at least over a substantial part of the trajectory it has to travel in the generator, has a small diameter which reduces statistical beam spread.

In charged-particles pattern generators of the relevant kind, such as for example in beam pattern generators, a charge-carrier image is projected onto an object to be patterned. This image may for example be formed by a single round spot, a rectangular spot with variable dimensions, as described in US 3491236, a one-dimensional or two-dimensional collection of circles or squares, and so on. In such generators it is usual to optimize to the highest possible total current while maintaining sufficient image sharpness, which implies a sufficiently small spot diameter in the case of round beams and good peripheral sharpness in the case of rectangular beams.

It has been found from calculations that the TD contribution to the beam diameter can be greatly reduced by using beams whose diameter is below a particular maximum value, which depends on other beam parameters. Since a pattern generator in accordance with the invention uses beams that satisfy this condition, it is possible even at relatively high current densities to work with thin beams, and a much greater freedom is obtained in the choice of accelerating voltage and the geometry with respect to the beam trajectories.

In a preferred embodiment a composite beam is used whose component beams have such a small lateral cross-section that the TD effect in them is reduced, and whose trajectories are sufficiently far apart to reduce the mutually interferring TD effects of the component beams.

To this end the pattern generator contains for example a matrix of emitting elements that produces a division of the beam from the moment of its emission. In particular, the emitting elements for electron beams are solid-state emitters which are grouped in a one-dimensional or two-dimensional array, for example a linear array, an orthogonal matrix or an array along one or more arcs of a circle. The individual emitters of such an array, which may be thermionic emitters, field emitters, plasma emitters or suchlike, may be controlled independently of each other either individually or in groups, both in current strength and in starting potential. This can be done by means of charged-particle optical devices set up near to or in the source, or in the case of solid-state emitters by means of electrodes controlled separately per emitter or per group of emitters.

In a further embodiment a collection of objects points, for example the said array of emitters, is image in or near a plane of a lens of the generator located close to an object to be patterned. In this embodiment a chromatic correction of spherical aberration can be applied. For this purpose a suitable potential distribution is applied to the array of emitters at the source. Thus, for example, by means of a radial variation of potential the usual positive spherical aberration of the charged particles can be optically precompensated. Since the spherical aberration can be reduced, it is possible to work with composite beams with a significantly larger collective aperture angle. In a preferred embodiment the beam aperture angle is optimized with respect to the reduced spherical aberration. For example, in the case of a beam pattern generator in which the beam is displaced in the main plane of the relevant lens for a perpendicular scan, the chromatic compensation of the spherical aberration can be carried out dynamically on the position of the beam in the lens. If this chromatic correction introduces velocity variations in the beam that are impermissibly large for good scanning, the correction can be made with a largely achromatic deflection field, for example formed by a combination of a magnetic and an electric field, with a chromatic deflection-compensating lens doublet or with an appropriately adapted gauze electrode in the final lens.

In the following a description will be given, with reference to the drawings, of a few preferred embodiments of the invention, in which:

Figure 1 shows an electron beam pattern generator in accordance with the invention,

Figure 2 shows schematic representations of beams of charge particles,

Figure 3 shows a graph in which the TD effect and the Boersch effect are plotted as a function of the beam diameter, and

Figure 4 shows a schematic drawing of a charged-particle optical system in accordance with the invention.

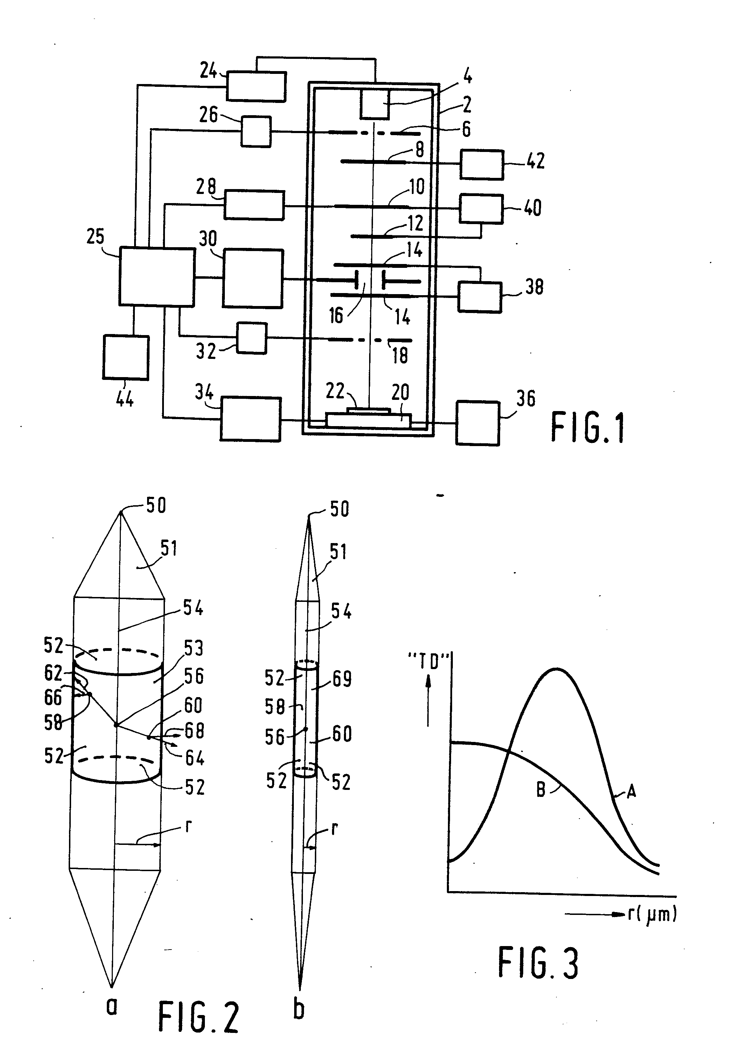

Figure 1 shows an electron-beam or iron-beam pattern generator contained in a housing 2, with a radiation source 4, a shaping-blanking device 6, a condenser lens system 8, a central diaphragm 10, a reducing lens system 12, a composite objective lens 14, a beam-deflection correction device 16, a beam-correction device 18 and an object carrier 20 with thereon an object 22 to be patterned, for example a silicon wafer or a mask plate. In the case of an ion-beam pattern generator the device 4 contains for example an ion-mass selection element. The beam correction device 10 contains for example a gauze adapted to a composite beam and containing electrodes for correcting spherical aberration.

A large of the optical system is otherwise substantially the same, at least in so far as relevant to the invention, apart from adaptations to the polarity and the mass-charge ratio of the different particles. For simplicity the apparatus will therefore be described herein after mainly as an electron-beam pattern generator. The electron-radiation source is preferably formed by a solid-state electron emitter or field emitter, and for a multi-beam generator by a collection of individual solid-state emitters or field emitters. For controlling the radiation source and in particular the array of individual emitters, a radiation-source control device 24 is included, which is connected to a central control device 25. Also connected to the central control device are a control device 26 for the shaping-blanking device 6, a control device 28 for the central diaphragm 10, a control device 30 for the scanning device 14, a control device 32 for the correction system 16, an adjustment device 34 and a measuring device 36 for the object carrier 20 and control devices 38, 40 and 42 for respectively the objective lens 14, the reducing lens system 12 and the condenser lens system 8. Further connected to the central control device is a memory-readout device 44 for the storage of data and for reading out target-relevant data for processing. The implementation and function of the various elements of the generator will now be described in more detail in so far as they are relevant to the invention.

Figure 2 shows very schematically an electron beam 51 emitted by an emitter 50, in which beam individual electrons 52 are randomly distributed over a volume of the beam. The volume of the beam is determined by a cylinder 43 around an axis 54 of the beam. All electrons considered are contained within a cylindrical surface 56.

From for example a central reference electron 56 all electrons experience a repulsive force directed along the extension of the connecting line between the central electron and the electron considered. For electrons 58 and 60 a force vector is indicated by 62 and 64 respectively and a component directed at right angles to the axis 54 is indicated by 66 and 68 respectively.

A cylinder 69 of figure 2b contains an equal number of electrons, so that for the same electron velocity the two beams represent an identical total beam current strength. It is therefore clear without being explicity shown that the components of the force vectors directed perpendicular to the axis will be much smaller here, and will be smaller the more the mutual distance of the electrons measured in the axial direction is greater than the beam diameter. The extreme case in which all electrons are located like a train on the axis 54 is free from any TD effect.

Figure 3 shows a coordinate system with the radius r of the beam plotted horizontally and a measure of the influence of the said statistical effects plotted vertically. A curve A shows the TD effect for a beam with constant current strength, while curve B shows the Boersch effect. In a region between values a and b for the beam radius r the TD effect is relatively large. By reducing to a value smaller than a´ the radius of beams whose radius of beams whose radius falls within that region, the TD effect can be reduced. A considerable gain can be achieved be breaking with the idea that the Coulomb forces will go on increasing as the beam becomes thinner, which has hitherto been taken as the rule of thumb. In the case of composite beams it is desirable to ensure that the mutual distance between the constituent beams is sufficiently large to avoid mutual influencing. It appears from figure 3 that in such thin beams the Boersch effect, see curve B, does not show any further increase, and therefore this effect will not give rise to further limitations.

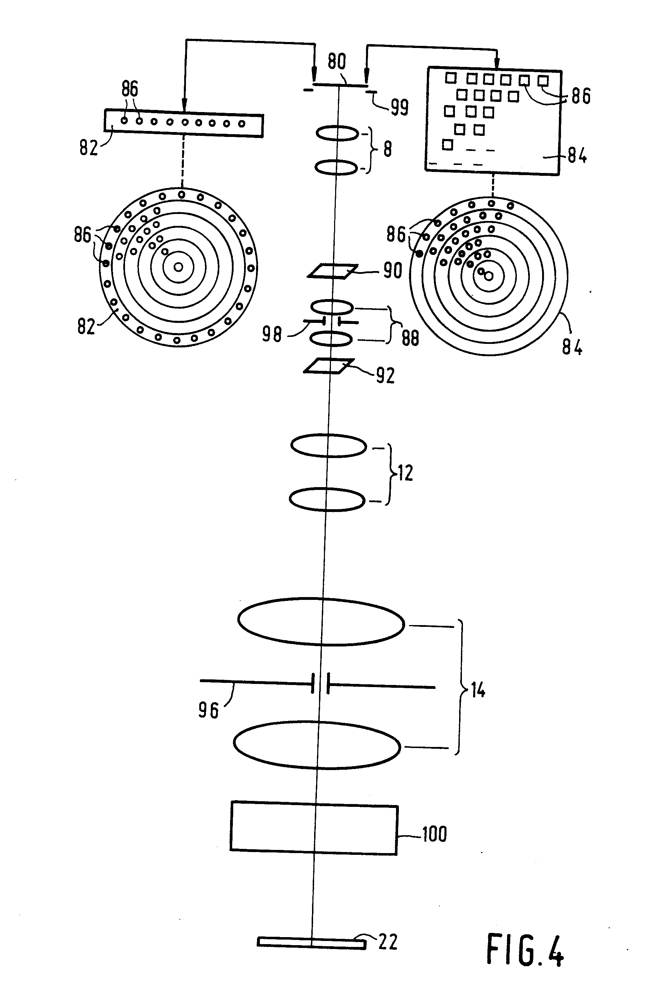

Dividing up a beam of charged particles can in principle be carried out at all positions in the generator. An example of such dividing up of such a beam is described in EP 87196. A beam division suitable for the purposes of the invention is that whereby the emitter produces a collection of sub-beams because the emitter contains a collection of individual emitting elements. For an electron-beam pattern generator as described in figure 4 the emitter is preferably formed by an array of solid-state emitters as described for example in Philips Journal of Research, Vol. 39, no. 3, 1984, pp 51-60, or by an array of field emitters as described for example in Journal Appl. Physics, Vol. 47, No.12, Dec. 1976, pp 5248 to 5263.

Such an array of emitters contains for example a collection of a few score to a few thousand individual emitters arranged for example in a matrix of 50 x 50 emitters. It is precisely due to the construction of emitters of this type that a virtually arbitrary choice can be made both of the number and of the mutual positioning of the emitter. A composite beam of this type can be used in accordance with a pattern generator described for example in US 4.151.422 for producing integrated circuits, as a scanning beam in a scanning-electron microscope and in corresponding processing or analytical equipment. It may thereby be advantageous to control for example groups of sub-beams separately, which for that purpose must be sufficiently far apart from each other at the relevant locations.

In the objective lens 14 in particular the composite beam may be affected to a relatively great extent by spherical aberration, since the beam at that location is relatively wide and since a large active lens field is often used here to ensure perpendicular landing of the beam. This can be largely corrected by applying different, suitably adapted starting potentials to individual emitter elements. This correction can be matched in a completely dynamic way to the beam geometry, and in the case of a beam with fixed orientation the correction then takes place radially over the array of emitter elements. When the beam is displaced over the lens surface the potential excursion of the emitter elements is able to follow this radial displacement dynamically or stepwise.

The spherical aberration of the objective lens can also be reduced by using a piece of gauze specifically made for the purpose and which, with associated electrodes, if fitted in or near the plane of the lens. Any displacement of the beam is then preferably carried out in mesh steps. This may arise for example in pattern generators for producing integrated circuit elements, where it is advantageous to be able to pattern a relatively large surface area without displacing the semiconductor wafer to be processed and where it is desired to avoid deviations resulting from the oblique incidence of the writing beam. Similar considerations may also apply to for example measuring equipment in which a beam of charged particles is used for example to inspect an integrated circuit element or chip after production. Here again it will be advantageous to be able to check a large surface area simultaneously, and a vertically incident beam can increase the reliability of the measurement.

An electron-optical column for a charged-particle pattern generator as for example given in figure 1 as shown in figure 4 and contains a composite source 80 which contains for example a linear array 82 or a matrix 84 of individual emitters 86. Each of the emitters has for example an active surface, i.e. a surface actually capable of emitting electrons, of for the example 1 $\mu$m². The mutual distance of the individual emitters is for example about 10$\mu$m and is determined, apart from technological constraints, by the mutual trajectory displacement effect. The mutual distance of the elementary beams in the objective lens amounts for example to about 100 μm.

The column is further equipped with a condenser lens system 8, a shaping system 88 with a first diaphragm 90, a second diaphragm 92 and a lens system 94, a reducing lens 12 and an objective lens 14 with a deflection device 96. The shaping system 88 includes a deflection device 98 for both the deflection for the beam shaping and for blanking.

When the objective lens 14 and the deflection device 96 have a large deflection-lens field, a chromatic correction for spherical aberration can be made by applying a potential excursion to the collection of individual emitters 86. For this purpose a solid-state emitter matrix can be provided with a controllable electrode system 99. The control for the dynamic case can be simplified by adapting the potential excursion for a predetermined fixed number of component areas in the objective lens field. The latter in particular can be achieved by means of a set of common electrodes for the individual emitters or for groups thereof. For beam shaping, which is widely used in particular for chip manufacture and for which the shaping system 88 serves, a loss of intensity due to the resultant variation in beam diameter can be compensated by increasing the current density in the remaining part of the beam. To this end the emitters of the source are adapted in terms of current density. When solid-state emitters or field emitters are used, this adaption can be made to the beam diameter variation even at very high control frequencies, so that a much faster control can be achieved than has hitherto been possible. Brightness control of this kind removes the need for time-consuming lens correction in the objective lens for the beam shaping, leaves a wider range in the beam shaping and results in reduced patterning time.

Between the object lens 14 and an object 22 an electron-optical device 100 can be used for correcting chromatic deflection errors that may occur in a beam with the particles having relatively large energy differences, as may occur in the case of chromatic compensation for spherical aberration. A more detailed description will be found in an article by Slingerland et al., in which these devices are described for an ion-beam pattern generator and which was published in Microcircuit 84 Proceedings Conference, Cambridge, p 381 et seq..

Although the invention has been described in the foregoing with reference to only a few embodiments, its application is certainly not limited to these. On the one hand the invention, due to the in fact aberration-free composite beam, opens up a whole range of possibilities for a priori compensation of optical errors in a charged-particle pattern generating system by the possibility of individually controlling each of the separate emitters, here described on the basis of the spherical aberration of mainly the objective lens. Furthermore, due to the possibility of very fast control of the emitters, or orders of magnitude into the giga hertz range, very fast beam control is possible both for the beam as a whole and for its individual component beams. Applications for the invention will thus be found more especially where fast control is desirable, for example in chip manufacture, where a beam with an exactly determined contour is required, and also in chip inspection, scanning-electron or ion pattern generators and in surface-analytical equipment in general in so far as they work with charged-particle beams. On the other hand the invention can also find applications where a low accelerating voltage is used, since it is precisely here that the disturbing deffects referred to are a substantial limiting factor. In this connection one might also think of analytical equipment for example for surface structure analysis with a high resolving power, and also of the use of a single very thin beam in accordance with the invention. The invention may further be very useful for example in image pick-up devices such as high-resolution television cameras, thanks to the absence of TD effects and the small scanning beam spot that can consequently be achieved. For tubes of this type with a relatively large target to be scanned, chromatic correction can again be applied as well as for the vertical landing of the beam, which is desired in this case as well. By dividing the matrix of emitters into groups which are for example geometrically separated from each other, a multibeam apparatus can be designed in which the invention can offer great advantages.

## Claims

1. Charged-particle pattern generator with a source and an optical system for generating and controlling a beam of charged particles, characterized in that beam-selection means are present for forming a beam of particles which, at least over a substantial part of a trajectory to be travelled by the beam in the generator, has a small diameter to reduce trajectory displacement.

2. Charged-particle pattern generator as claimed in Claim 1, characterized in that a device is contained therein for forming a fan of multiple component beams each of which has a small beam diameter to reduce trajectory displacement.

3. Charged-particle pattern generator as claimed in Claims 1 or 2, characterized in that the beam-selection means are arranged to form a fan of component beams having a small diameter to reduce trajectory displacement, which component beams are mutually spaced at distances such that mutual trajectory displacement effects are reduced.

4. Charged-particle pattern generator as claimed in Claims 2 or 3, characterized in that the source contains a linear array or a matrix of individual emitters for generating a fan component beams.

5. Charged-particle pattern generator as claimed in Claims 2 or 3, characterized in that the optical system is equipped with a device for dividing up a beam of charged particles into a fan of component beams.

6. Charged-particle generator as claimed in any one of the foregoing Claims, characterized in that the charged particles are ions.

7. Charged-particle pattern generator as claimed in any one of Claims 1 to 5, characterized in that the chargedparticles are electrons.

8. Charged-particle pattern generator as claimed in Claim 7, characterized in that the source contains a single solid-state electron emitter or a collection of such emitters.

9. Charged-particle pattern generator as claimed in Claim 7, characterized in that the source contains a single field emitter or a collection of such emitters.

10. Charged-particle pattern generator as claimed in any one of the foregoing Claims, characterized in that a charged-particle optical device images a collection of particles in or near a lens of an objective lens system of the charged-particle optical system of the pattern generator.

11. Charged-particle pattern generator as claimed in Claim 10, characterized in that the objective lens forms part of a shaped-beam pattern generator.

12. Charged-particle pattern generator as claimed in Claim 10, characterized in that the objective lens forms part of a scanning-beam pattern generator.

13. Charged-particle pattern generator as claimed in Claim 10, characterized in that potentials can be applied to individual emitters of a collection of emittersto provide chromatic compensation for spherical aberration in the optical system.

14. Charged-particle pattern generator as claimed in any one of the Claims 10 to 13, characterized in that the objective lens contains a gauze with a control electrode to correct spherical aberration.

15. Charged-particle pattern generator as claimed in Claims 13 or 14, characterized in that a maximum permissible aperture angle for an emitted fan of component beams is matched to an objective lens corrected for spherical aberration.

16. Charged-particle pattern generator as claimed in Claims 13, 14 or 15, characterized in that the potential distribution of the individual emitters of a collection of emitters dynamically follows a scanning movement of the collective beam in the lens system.

17. Charged-particle pattern generator as claimed in Claim 16, characterized in that the dynamic correction potential follows the scanning movement of the beam in the objective lens system.

18. Charged-particle pattern generator as claimed in Claim 17, characterized in that the size of a step for the stepwise following of a radial beam movement in the objective lens system is matched to mesh dimensions of the gauze.

19. Charged-particle pattern generator as claimed in any one of Claims 16, 17 or 18, characterized in that an area of a target to be scanned by the scanning beam is matched in surface extension to the spherical aberration correction.

20. Charged-particle pattern generator as claimed in any one of Claims 16, 17, 18 or 19, characterized in that a combined magnetic-electric deflection field is used for achromatic beam scanning.

21. Charged-particle pattern generator as claimed in any one of Claims 13, 14, 15 or 16, characterized in that a chromatic beam error in the beam scanning device as compensated with a projection doublet.

22. Charged-particle pattern generator as claimed in any one of the foregoing Claims, characterized in that beam-shaping is used therein together with dynamic brightness control which is matched to the beam shaping in such a way as to keep the effect of non-static beam spread on the beam constant.

23. Charged-particle pattern generator as claimed in Claim 22, characterized in that the particles source contains a collection of solid-state emitters which is equipped with an electrode system for the dynamic brightness control.

FIG.1

a    FIG.2    b

FIG.3

FIG.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,Y | EP-A-0 087 196  (LE POOLE) * Figures 1-3; page 2, line 10 - page 3, line 1; page 4, line 18 - page 10, line 27 * | 1 | H 01 J   37/30 H 01 J   37/317 H 01 J   37/153 |
| A | | 2-7,10 ,12 | |
| | --- | | |
| Y | SOLID-STATE TECHNOLOGY, vol. 27, no. 9, September 1984, pages 223-227, Port Washington, New York, US; H.C. PFEIFFER: "Direct write electron beam lithography - A production line reality" *   Paragraph:  "Limitations  and solutions" * | 1 | |
| | --- | | TECHNICAL FIELDS SEARCHED (Int. Cl.4) |
| A | | 7,11, 21 | H 01 J   37/00 |
| | --- | | |
| A | FR-A-2 443 085  (THOMSON CSF) * Figure 3; page 4, lines 11-40 * | 8,9,16 | |
| | --- | | |
| A | EP-A-0 092 873  (ROELOFS) * Figures; page 3, line 38 - page 5, line 4 * | 12 | |
| | ----- | | |

The present search report has been drawn up for all claims

| Place of search | Date of completion of the search | Examiner |
|---|---|---|
| THE HAGUE | 14-11-1986 | SCHAUB G.G. |